# EUROPEAN PATENT APPLICATION

(11) **EP 4 485 802 A1**
(43) Date of publication of application: **01.01.2025**
(21) Application number: 23207630.7
(22) Date of filing: 03.11.2023
(51) Int. Cl.: H03K 19/17796, H01L 25/065, H01L 23/00, G06F 13/10, H03K 19/17736, H01L 23/538

(54) **CIRCUIT SYSTEMS AND METHODS FOR TRANSMITTING SIGNALS BETWEEN DEVICES**

(30) Priority: 30.06.2023 US 202318216867
(71) Applicant: Intel Corporation, Santa Clara, CA 95054 (US)
(72) Inventor: HOSSAIN, Md Altaf, Portland, 97229 (US); KUMASHIKAR, Mahesh, 560066 Bangalore (IN); NALAMALPU, Ankireddy, Portland, 97229 (US); TANG, Lai Guan, 11200 Penang (MY)
(74) Representative: Viering, Jentschura & Partner mbB Patent- und Rechtsanwälte

(57) **Abstract**

A circuit system includes a support device (100) that has first and second conductors (22, 24). The circuit system also includes first, second, and third integrated circuits (101, 102, 104) that are coupled to the support device. The second integrated circuit (102) includes a peripheral region (122). The peripheral region includes a third conductor (32) coupled between the first and the second conductors. The circuit system is configured to transmit a signal from the first integrated circuit (101) through the first conductor, the third conductor, and the second conductor to the third integrated circuit (104). The first and the third integrated circuits are positioned diagonally in the circuit system.

## Description

### TECHNICAL FIELD

The present disclosure relates to electronic circuit system and methods, and more particularly to circuit systems and methods for transmitting signals between devices.

### BACKGROUND ART

Many modern electronic circuit systems include integrated circuit (IC) packages. An integrated circuit (IC) package can contain multiple integrated circuit dies. The integrated circuit dies in an IC package can, for example, be mounted on an interposer or a package substrate.

A configurable integrated circuit is a type of integrated circuit that can be configured by a user to implement desired custom logic functions. In a typical scenario, a logic designer uses computer-aided design (CAD) tools to design a custom circuit design. When the design process is complete, the computer-aided design tools generate configuration data. The configuration data is then loaded into configuration memory elements that configure configurable logic circuits in the configurable integrated circuit to perform the functions of the custom circuit design.

### BRIEF DESCRIPTION OF DRAWINGS

Figure 1 is a diagram that illustrates a top down perspective of an example of a circuit system that includes a support device and 4 integrated circuits.
Figure 2 is a diagram that illustrates a top down perspective of an example of a circuit system that includes a support device and 8 integrated circuits.
Figure 3A is a diagram that illustrates a cross sectional perspective of an example of a portion of the circuit system of FIG. 1.
Figure 3B is a diagram that illustrates a cross sectional perspective of an example of a portion of the circuit system of FIG. 1 or 2 with two sets of vertically stacked integrated circuits.
Figure 4 is a diagram that illustrates a cross sectional perspective of an example of a portion of the circuit system of FIG. 2.
Figure 5 illustrates an example of a programmable logic integrated circuit (IC) that can be, for example, any one or more of the integrated circuits disclosed herein with respect to FIGS. 1-4.

### DETAILED DESCRIPTION

Some electronic circuit systems include multiple integrated circuits (ICs) in the same package. As an example, two, three, four, or more ICs can be housed in the same package. The integrated circuits in the package can, for example, be coupled together through a package substrate or interposer in the package. As another example, two integrated circuits can be stacked vertically and coupled together in a 3-dimensional (3D) arrangement. A single integrated circuit (IC) package can, for example, be designed to house multiple different types of ICs. Some IC packages include interconnection bridges. However, an interconnections bridge only couples together two ICs that are adjacent to each other in the IC package.

Configurable integrated circuits (ICs) can be used for emulation and prototyping. As examples, a circuit system can have 4-8 configurable IC dies in one IC package. Previously known die-to-die interfaces for IC packages have high latency when IC dies in an IC package that are orientated diagonally from a top down perspective communicate with each other. Also, previously known die-to-die interfaces consume a substantial amount of power, which limits performance.

According to some examples disclosed herein, a circuit system includes a support device and first, second, and third integrated circuits. The support device supports the integrated circuits in the circuit system. The first and third integrated circuits are coupled together in the circuit system through conductors in the second integrated circuit and in the support device. The circuit system can be, for example, an integrated circuit package. The support device can be, for example, a package substrate or an interposer. The first, second, and third integrated circuits can, for example, be coupled together through conductors in interconnection bridges in the support device. The conductors in the support device and in the second integrated circuit provide electrical pathways for signals to be transmitted between the first and third integrated circuits in the circuit system. As examples, the conductors can be routed horizontally, vertically, diagonally, or in a stepped configuration. The conductors provide reduced latency and higher bandwidth pathways between the first and third integrated circuits compared to previously known circuit systems. As a result, the circuit systems disclosed herein can have improved performance and consume less power than previously known circuit systems without requiring increased cost.

One or more specific examples are described below. In an effort to provide a concise description of these examples, not all features of an actual implementation are described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

Throughout the specification, and in the claims, the term "connected" means a direct electrical connection between the circuits that are connected, without any intermediary devices. The term "coupled" means either a direct electrical connection between circuits or an indirect electrical connection through one or more passive or active intermediary devices that allows the transfer of information between circuits. The term "circuit" may mean one or more passive and/or active electrical components that are arranged to cooperate with one another to provide a desired function.

This disclosure discusses integrated circuit devices, including programmable (configurable) integrated circuits, such as field programmable gate arrays (FPGAs). As discussed herein, an integrated circuit (IC) can include hard logic and/or soft logic. As used herein, "hard logic" generally refers to circuits in an integrated circuit device that are not programmable by an end user. The circuits in an integrated circuit device (e.g., in a programmable IC) that are programmable by the end user are referred to as "soft logic."

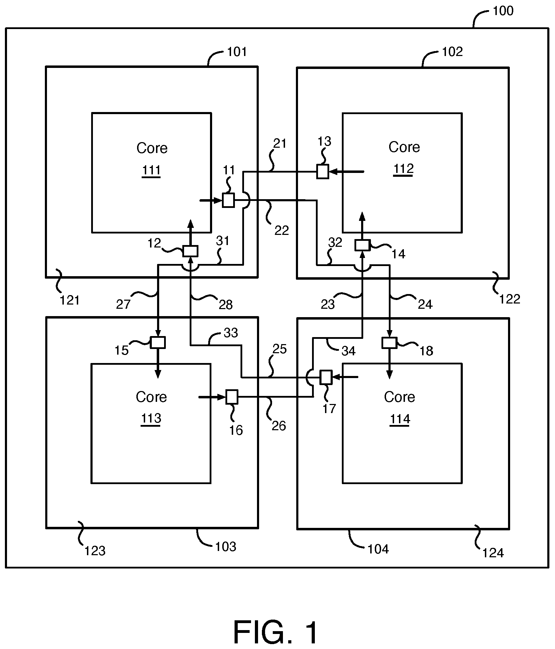

Figure 1 is a diagram that illustrates a top down perspective of an example of a circuit system that includes a support device 100 and 4 integrated circuits 101-104. The circuit system of FIG. 1 is a multi-chip module. Each of the integrated circuits (ICs) 101-104 is an individual integrated circuit (IC) die that is mounted on, and coupled to, the support device 100. Each of the ICs 101-104 can be any type of IC, such as a configurable IC, a microprocessor IC, a graphics processing unit IC, a memory IC, an application specific IC, a transceiver IC, a memory IC, etc. The circuit system of FIG. 1 can be, for example, an integrated circuit (IC) package. The support device 100 supports ICs 101-104. As examples, the support device 100 can be a package substrate or an interposer. The ICs 101-104 can, as examples, be coupled to conductors in the support device 100 through conductive bumps, balls, or pillars. The support device 100 includes conductors, such as conductors 21-28. Conductors 21-28 can, for example, be conductors in interconnection bridges that are embedded in the support device 100. Each of the interconnection bridges can couple together an adjacent pair of the ICs 101-104. As other examples, the conductors 21-28 can be in an interposer or in a package substrate.

Each of the ICs of FIG. 1 includes a core region of circuits and conductors and a peripheral region of circuits and conductors. Conductors are also referred to as wires or interconnects. Thus, ICs 101, 102, 103, and 104 include core regions 111, 112, 113, and 114 and peripheral regions 121, 122, 123, and 124, respectively. In implementations of the circuit system of FIG. 1 in which ICs 101-104 are configurable ICs, core regions 111-114 include arrays of configurable logic circuits.

The peripheral regions 121, 122, 123, and 124 of ICs 101, 102, 103, and 104 include time division multiplexer (TDM) circuits 11-12, 13-14, 15-16, and 17-18, respectively, as shown in FIG. 1. Each of the TDM circuits 11-18 can perform time division multiplexing on signals using a local clock signal that is synchronous or asynchronous with a system clock signal. In addition, the peripheral regions 121, 122, 123, and 124 include die-to-die conductors 31, 32, 33, and 34, respectively. Each of the die-to-die conductors 31, 32, 33, and 34 couples a first external terminal of the IC to a second external terminal of the IC. The external terminals can be, for example, conductive pads or pins of the IC. The die-to-die conductors 31, 32, 33, and 34 can be programmable interconnection conductors or non-programmable (hardened) conductors.

The circuit system of FIG. 1 includes signal paths for routing electrical signals between the ICs that are oriented diagonally in the top down perspective shown in FIG. 1. Each of these signal paths is routed through conductors in the support device 100 and an intermediate one of the ICs. For example, a first signal path can route a signal from TDM circuit 11 in IC 101 through conductor 22 in support device 100, conductor 32 in IC 102, and conductor 24 in support device 100 to an input of TDM circuit 18 in IC 104. Logic circuitry in core region 111 initially transmits signals to TDM circuit 11 in IC 101. TDM circuit 11 can perform time division multiplexing on the signals received from core region 111 to generate a signal that is transmitted from TDM circuit 11 through conductors 22, 32, and 24 to the input of TDM circuit 18 in IC 104. TDM circuit 18 then performs time division multiplexing on the signal received through conductors 22, 32, and 24 to generate signals that are transmitted to circuitry in core region 114. Thus, the signal is transmitted from IC 101 to IC 104 through a conductor 32 in the peripheral region 122 of IC 102 without being routed through conductors or circuits in core region 112, which reduces power consumption and latency.

As another example, a second signal path can route a signal from TDM circuit 13 in IC 102 through conductor 21 in support device 100, conductor 31 in IC 101, and conductor 27 in support device 100 to an input of TDM circuit 15 in IC 103. Logic circuitry in core region 112 initially transmits signals to TDM circuit 13 in IC 102. TDM circuit 13 can perform time division multiplexing on the signals received from core region 112 to generate a signal that is transmitted from TDM circuit 13 through conductors 21, 31, and 27 to the input of TDM circuit 15 in IC 103. TDM circuit 15 then performs time division multiplexing on the signal received through conductors 21, 31, and 27 to generate signals that are transmitted to circuitry in core region 113. Thus, the signal is transmitted from IC 102 to IC 103 through a conductor 31 in the peripheral region 121 of IC 101 without being routed through conductors or circuits in core region 111, which reduces power consumption and latency.

As yet another example, a third signal path can route a signal from TDM circuit 16 in IC 103 through conductor 26 in support device 100, conductor 34 in IC 104, and conductor 23 in support device 100 to an input of TDM circuit 14 in IC 102. Logic circuitry in core region 113 initially transmits signals to TDM circuit 16 in peripheral region 123. TDM circuit 16 can perform time division multiplexing on the signals received from core region 113 to generate a signal that is transmitted from TDM circuit 16 through conductors 26, 34, and 23 to the input of TDM circuit 14 in IC 102. TDM circuit 14 then performs time division multiplexing on the signal received through conductors 26, 34, and 23 to generate signals that are transmitted to circuitry in core region 112. Thus, the signal is transmitted from IC 103 to IC 102 through a conductor 34 in the peripheral region 124 of IC 104 without being routed through conductors or circuits in core region 114, which reduces power consumption and latency.

As yet another example, a fourth signal path can route a signal from TDM circuit 17 in IC 104 through conductor 25 in support device 100, conductor 33 in IC 103, and conductor 28 in support device 100 to an input of TDM circuit 12 in IC 101. Logic circuitry in core region 114 initially transmits signals to TDM circuit 17 in IC 104. TDM circuit 17 can perform time division multiplexing on the signals received from core region 114 to generate a signal that is transmitted from TDM circuit 17 through conductors 25, 33, and 28 to the input of TDM circuit 12 in IC 101. TDM circuit 12 then performs time division multiplexing on the signal received through conductors 25, 33, and 28 to generate signals that are transmitted to circuitry in core region 111. Thus, the signal is transmitted from IC 104 to IC 101 through a conductor 33 in the peripheral region 123 of IC 103 without being routed through conductors or circuits in core region 113, which reduces power consumption and latency. Each of the signals transmitted between the TDM circuits can be, e.g., a single signal with a stream of serially transmitted bits.

In some embodiments, the circuit system of FIG. 1 can include additional ICs (not shown) that are vertically stacked on top of one or more of ICs 101-104 in a three-dimensional (3D) arrangement. In these embodiments, any one or more of the first through fourth signal paths discussed above and shown in FIG. 1 can route signals between two ICs that are vertically stacked in a 3D arrangement and oriented diagonally in the top down view of FIG. 1. For example, IC 101 can receive data from an IC that is vertically stacked above IC 101, and the circuit system can route the received data through the first signal path from IC 101 to IC 104 (and optionally from IC 104 to another IC that is vertically stacked above IC 104). As another example, IC 102 can receive data from an IC that is vertically stacked above IC 102, and the circuit system can route the received data through the second signal path from IC 102 to IC 103 (and optionally from IC 103 to another IC that is vertically stacked above IC 103).

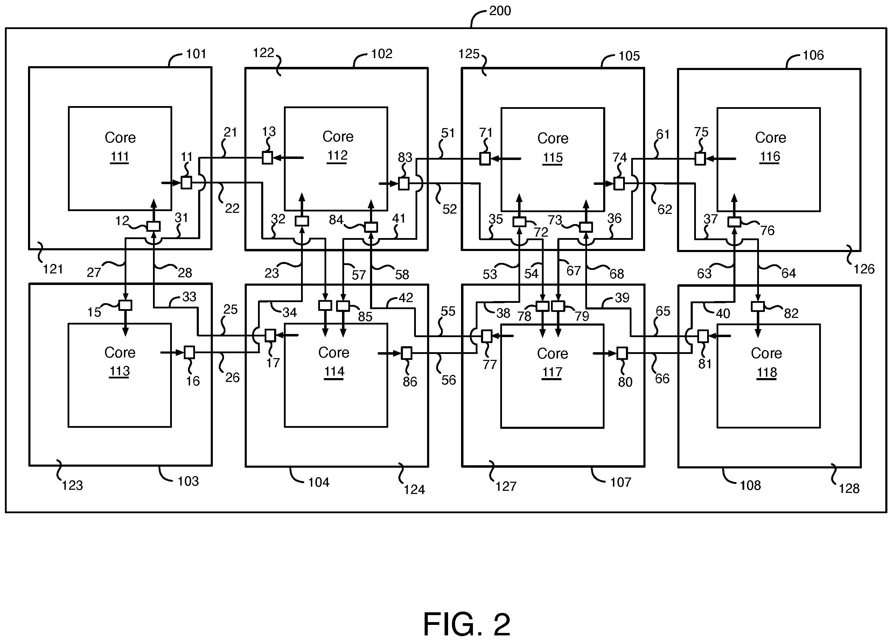

Figure 2 is a diagram that illustrates a top down perspective of an example of a circuit system that includes a support device 200 and 8 integrated circuits 101-108. The circuit system of FIG. 2 is a multi-chip module. Each of the integrated circuits (ICs) 101-108 is an individual integrated circuit (IC) die that is mounted on, and coupled to, the support device 200. Each of the ICs 101-108 is also referred to as an external device relative to the other ICs. Each of the ICs 101-108 can be any type of IC, such as a configurable IC, a microprocessor IC, a graphics processing unit IC, a memory IC, an application specific IC, a transceiver IC, a memory IC, etc. The circuit system of FIG. 2 can be, for example, an integrated circuit (IC) package. The support device 200 supports ICs 101-108. As examples, the support device 200 can be a package substrate or an interposer. The ICs 101-108 can, as examples, be coupled to conductors in the support device 200 through conductive bumps, balls, or pillars. The support device 200 includes conductors, such as conductors 21-28, 51-58, and 61-68. Conductors 21-28, 51-58, and 61-68 can, for example, be conductors in interconnection bridges that are embedded in the support device 200. Each of the interconnection bridges can couple together an adjacent pair of the ICs 101-108. As other examples, the conductors 21-28, 51-58, and 61-68 can be in an interposer or in a package substrate.

Each of the ICs 101-108 includes a core region of circuits and conductors and a peripheral region of circuits and conductors. ICs 101-104 are described above. ICs 105, 106, 107, and 108 include core regions 115, 116, 117, and 118 and peripheral regions 125, 126, 127, and 128, respectively. In implementations of the circuit system of FIG. 2 in which ICs 101-108 are configurable ICs, core regions 111-118 include arrays of configurable logic circuits.

The peripheral regions 125, 126, 127, and 128 of ICs 105, 106, 107, and 108 include time division multiplexer (TDM) circuits 71-74, 75-76, 77-80, and 81-82, respectively, as shown in FIG. 2. Each of the TDM circuits 71-82 can perform time division multiplexing on signals using a local clock signal that is synchronous or asynchronous with a system clock signal. Also, in the circuit system of FIG. 2, IC 102 includes TDM circuits 83-84, and IC 104 includes TDM circuits 85-86. The peripheral regions 125, 126, 127, and 128 include die-to-die conductors 35-36, 37, 38-39, and 40, respectively. Also, in the circuit system of FIG. 2, IC 102 includes die-to-die conductor 41 in peripheral region 122, and IC 104 includes die-to-die conductor 42 in peripheral region 124. Each of the die-to-die conductors 35-42 couples a first external terminal of the IC to a second external terminal of the IC. The external terminals can be, for example, conductive pads or pins of the IC. The die-to-die conductors 35-42 can be programmable interconnection conductors or non-programmable (hardened) conductors.

The circuit system of FIG. 2 includes signal paths for routing electrical signals between the ICs that are oriented diagonally in the top down perspective shown in FIG. 2. Each of these signal paths is routed through conductors in the support device 200 and in an intermediate one of the ICs. Four signal paths are described above with respect to FIG. 1. A fifth signal path can route a signal from TDM circuit 83 in IC 102 through conductor 52 in support device 200, conductor 35 in IC 105, and conductor 54 in support device 200 to an input of TDM circuit 78 in IC 107. A sixth signal path can route a signal from TDM circuit 86 in IC 104 through conductor 56 in support device 200, conductor 38 in IC 107, and conductor 53 in support device 200 to an input of TDM circuit 72 in IC 105. A seventh signal path can route a signal from TDM circuit 71 in IC 105 through conductor 51 in support device 200, conductor 41 in IC 102, and conductor 57 in support device 200 to an input of TDM circuit 85 in IC 104. An eighth signal path can route a signal from TDM circuit 77 in IC 107 through conductor 55 in support device 200, conductor 42 in IC 104, and conductor 58 in support device 200 to an input of TDM circuit 84 in IC 102.

A ninth signal path can route a signal from TDM circuit 74 in IC 105 through conductor 62 in support device 200, conductor 37 in IC 106, and conductor 64 in support device 200 to an input of TDM circuit 82 in IC 108. A tenth signal path can route a signal from TDM circuit 75 in IC 106 through conductor 61 in support device 200, conductor 36 in IC 105, and conductor 67 in support device 200 to an input of TDM circuit 79 in IC 107. An eleventh signal path can route a signal from TDM circuit 80 in IC 107 through conductor 66 in support device 200, conductor 40 in IC 108, and conductor 63 in support device 200 to an input of TDM circuit 76 in IC 106. A twelfth signal path can route a signal from TDM circuit 81 in IC 108 through conductor 65 in support device 200, conductor 39 in IC 107, and conductor 68 in support device 200 to an input of TDM circuit 73 in IC 105.

Each of these signals is transmitted between diagonally positioned ICs through a conductor in the peripheral region of an intermediate IC in one of the 12 signal paths without being routed through conductors or circuits in the core region of the intermediate IC. Routing the signals through the conductors in the peripheral regions of the intermediate ICs reduces power consumption and latency compared to routing the signals through the core regions in the intermediate ICs. By reducing the latency in signal transmission between diagonally positioned ICs, overall improved performance can be achieved by using a higher maximum signal frequency. The circuit systems of FIGS. 1 and 2 also consume lower power compared to previously known systems, because the circuit systems of FIGS. 1-2 do not need to use steering and buffering logic circuitry in the intermediate ICs for communications between the diagonally positioned ICs.

In some embodiments, the circuit system of FIG. 2 can include additional ICs (not shown) that are vertically stacked on top of one or more of ICs 101-108 in a three-dimensional (3D) arrangement. In these embodiments, any one or more of the first through twelfth signal paths discussed above and shown in FIG. 2 can route signals between two ICs that are vertically stacked in a 3D arrangement and oriented diagonally in the top down view of FIG. 2. For example, IC 105 can receive data from an IC that is vertically stacked above IC 105, and the circuit system can route the received data through the ninth signal path from IC 105 to IC 108 (and optionally from IC 108 to another IC that is vertically stacked above IC 108). As another example, IC 106 can receive data from an IC that is vertically stacked above IC 106, and the circuit system can route the received data through the tenth signal path from IC 106 to IC 107 (and optionally from IC 107 to another IC that is vertically stacked above IC 107).

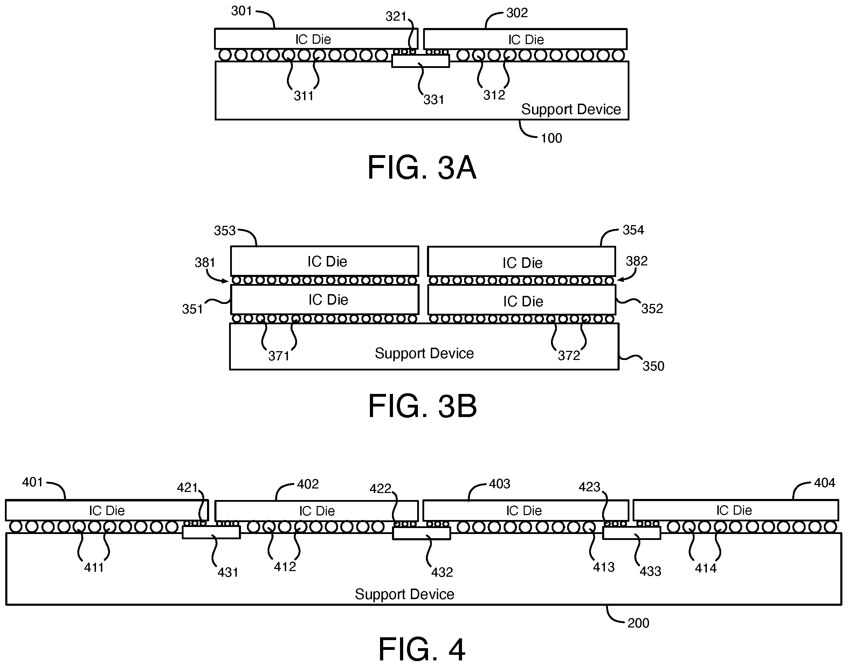

Figure 3A is a diagram that illustrates a cross sectional perspective of an example of a portion of the circuit system of FIG. 1. In FIG. 3A, integrated circuit (IC) dies 301 and 302 are coupled to conductors in the support device 100 through conductive balls or bumps 311 and 312, respectively. ICs 301-302 can be any adjacent pair of ICs in FIG. 1, i.e., ICs 101-102, ICs 101 and 103, ICs 102 and 104, or ICs 103-104.

In the example of FIG. 3A, the support device 100 includes an embedded multi-die interconnection bridge (EMIB) 331. The EMIB 331 is coupled to ICs 301 and 302 through conductive micro-bumps 321. Signals are transmitted between ICs 301 and 302 through bumps 321 and conductors in EMIB 331. In an implementation in which EMIB 331 couples ICs 101-102, ICs 102 and 104, ICs 103-104, or ICs 101 and 103, conductors 21-22, 23-24, 25-26, or 27-28 shown in FIG. 1 are in EMIB 331, respectively.

Figure 3B is a diagram that illustrates a cross sectional perspective of an example of a portion of the circuit system of FIG. 1 or 2 with two sets of vertically stacked integrated circuits. FIG. 3B shows four integrated circuit (IC) dies 351-354. ICs 351-354 can have any combinations of different IC types, such as configurable ICs, microprocessor ICs, graphics processing unit ICs, memory ICs, application specific ICs, transceiver ICs, memory ICs, etc. ICs 351-352 can be any adjacent or diagonal pair of ICs 101-108 shown in FIG. 1 or FIG. 2. ICs 351 and 352 are coupled to conductors in a support device 350 (e.g., support device 100 or 200) and/or an EMIB through conductive balls or bumps 371 and 372, respectively. ICs 353 and 354 are vertically stacked on top of ICs 351 and 352, respectively, in a 3D configuration. ICs 353 and 354 are coupled to ICs 351 and 352 through conductive balls or bumps 381 and 382, respectively. In alternative implementations, some or all of the conductive bumps of FIG. 3B can be replaced with conductive pillars. Signals can be transmitted between ICs 353 and 354 through the conductive bumps and the signal paths described above and shown in FIGS. 1-2. If ICs 351-354 are configurable ICs, then the signal paths can provide improved performance for emulation.

Figure 4 is a diagram that illustrates a cross sectional perspective of an example of a portion of the circuit system of FIG. 2. In FIG. 4, integrated circuit (IC) dies 401, 402, 403, and 404 are coupled to conductors in the support device 200 through conductive balls or bumps 411, 412, 413, and 414, respectively. ICs 401-404 can be, for example, ICs 101-102 and 105-106, or ICs 103-104 and 107-108, respectively.

In the example of FIG. 4, the support device 200 includes embedded multi-die interconnection bridges (EMIBs) 431-433. EMIB 431 is coupled to ICs 401 and 402 through conductive micro-bumps 421. Signals are transmitted between ICs 401 and 402 through bumps 421 and conductors in EMIB 431. EMIB 432 is coupled to ICs 402 and 403 through conductive micro-bumps 422. Signals are transmitted between ICs 402 and 403 through bumps 422 and conductors in EMIB 432. EMIB 433 is coupled to ICs 403 and 404 through conductive micro-bumps 423. Signals are transmitted between ICs 403 and 404 through bumps 423 and conductors in EMIB 433.

In an implementation of the circuit system of FIG. 2, EMIBs 431, 432, and 433 include conductors 21-22, 51-52, and 61-62, respectively. In another implementation of the circuit system of FIG. 2, EMIBs 431, 432, and 433 include conductors 25-26, 55-56, and 65-66, respectively.

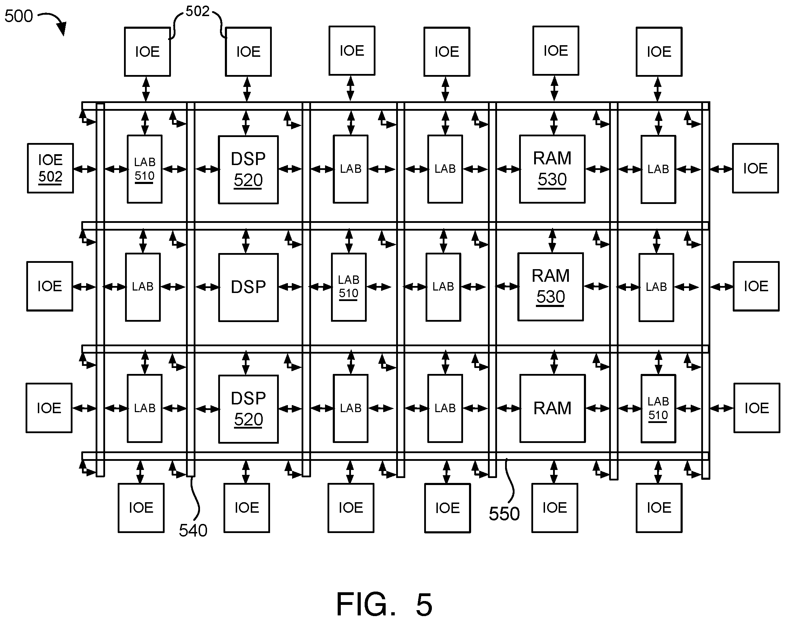

Figure 5 illustrates an example of a programmable (i.e., configurable) logic integrated circuit (IC) 500 that can be, for example, any one or more of the ICs 101-108, 301-302, 351-354, or 401-404 disclosed herein with respect to FIGS. 1-4. As shown in FIG. 5, the programmable logic integrated circuit (IC) 500 includes a two-dimensional array of configurable functional circuit blocks, including configurable logic array blocks (LABs) 510 and other functional circuit blocks, such as random access memory (RAM) blocks 530 and digital signal processing (DSP) blocks 520. Functional blocks such as LABs 510 can include smaller programmable logic circuits (e.g., logic elements, logic blocks, or adaptive logic modules) that receive input signals and perform custom functions on the input signals to produce output signals. The configurable functional circuit blocks shown in FIG. 5 can, for example, be located in any of the core regions 111-118 of ICs 101-108, respectively.

In addition, programmable logic IC 500 can have input/output elements (IOEs) 502 for driving signals off of programmable logic IC 500 and for receiving signals from other devices. Input/output elements 502 can include parallel input/output circuitry, serial data transceiver circuitry, differential receiver and transmitter circuitry, or other circuitry used to connect one integrated circuit to another integrated circuit. As shown, input/output elements 502 can be located around the periphery of the chip. If desired, the programmable logic IC 500 can have input/output elements 502 arranged in different ways. For example, input/output elements 502 can form one or more columns, rows, or islands of input/output elements that may be located anywhere on the programmable logic IC 500.

The programmable logic IC 500 can also include programmable interconnect circuitry in the form of vertical routing channels 540 (i.e., interconnects formed along a vertical axis of programmable logic IC 500) and horizontal routing channels 550 (i.e., interconnects formed along a horizontal axis of programmable logic IC 500), each routing channel including at least one conductor to route at least one signal.

Note that other routing topologies, besides the topology of the interconnect circuitry depicted in FIG. 5, may be used. For example, the routing topology can include wires that travel diagonally or that travel horizontally and vertically along different parts of their extent as well as wires that are perpendicular to the device plane in the case of three dimensional integrated circuits. The driver of a wire can be located at a different point than one end of a wire.

Furthermore, it should be understood that embodiments disclosed herein with respect to FIGS. 1-4 can be implemented in any integrated circuit or electronic system. If desired, the functional blocks of such an integrated circuit can be arranged in more levels or layers in which multiple functional blocks are interconnected to form still larger blocks. Other device arrangements can use functional blocks that are not arranged in rows and columns.

Programmable logic IC 500 can contain programmable memory elements. Memory elements can be loaded with configuration data using input/output elements (IOEs) 502. Once loaded, the memory elements each provide a corresponding static control signal that controls the operation of an associated configurable functional block (e.g., LABs 510, DSP blocks 520, RAM blocks 530, or input/output elements 502).

In a typical scenario, the outputs of the loaded memory elements are applied to the gates of metal-oxide-semiconductor field-effect transistors (MOSFETs) in a functional block to turn certain transistors on or off and thereby configure the logic in the functional block including the routing paths. Programmable logic circuit elements that can be controlled in this way include multiplexers (e.g., multiplexers used for forming routing paths in interconnect circuits), look-up tables, logic arrays, AND, OR, XOR, NAND, and NOR logic gates, pass gates, etc.

The programmable memory elements can be organized in a configuration memory array having rows and columns. A data register that spans across all columns and an address register that spans across all rows can receive configuration data. The configuration data can be shifted onto the data register. When the appropriate address register is asserted, the data register writes the configuration data to the configuration memory bits of the row that was designated by the address register.

In certain embodiments, programmable logic IC 500 can include configuration memory that is organized in sectors, whereby a sector can include the configuration RAM bits that specify the functions and/or interconnections of the subcomponents and wires in or crossing that sector. Each sector can include separate data and address registers.

The programmable logic IC of FIG. 5 is merely one example of an IC that can be used with embodiments disclosed herein. The embodiments disclosed herein can be used with any suitable integrated circuit or system. For example, the embodiments disclosed herein can be used with numerous types of devices such as processor integrated circuits, central processing units, memory integrated circuits, graphics processing unit integrated circuits, application specific standard products (ASSPs), application specific integrated circuits (ASICs), and programmable logic integrated circuits. Examples of programmable logic integrated circuits include programmable arrays logic (PALs), programmable logic arrays (PLAs), field programmable logic arrays (FPLAs), electrically programmable logic devices (EPLDs), electrically erasable programmable logic devices (EEPLDs), logic cell arrays (LCAs), complex programmable logic devices (CPLDs), and field programmable gate arrays (FPGAs), just to name a few.

The integrated circuits disclosed in one or more embodiments herein can be part of a data processing system that includes one or more of the following components: a processor; memory; input/output circuitry; and peripheral devices. The data processing system can be used in a wide variety of applications, such as computer networking, data networking, instrumentation, video processing, digital signal processing, or any suitable other application. The integrated circuits can be used to perform a variety of different logic functions.

In general, software and data for performing any of the functions disclosed herein can be stored in non-transitory computer readable storage media. Non-transitory computer readable storage media is tangible computer readable storage media that stores data and software for access at a later time, as opposed to media that only transmits propagating electrical signals (e.g., wires). The software code may sometimes be referred to as software, data, program instructions, instructions, or code. The non-transitory computer readable storage media can, for example, include computer memory chips, non-volatile memory such as non-volatile random-access memory (NVRAM), one or more hard drives (e.g., magnetic drives or solid state drives), one or more removable flash drives or other removable media, compact discs (CDs), digital versatile discs (DVDs), Blu-ray discs (BDs), other optical media, and floppy diskettes, tapes, or any other suitable memory or storage device(s).

Additional examples are now described. Example 1 is an integrated circuit comprising: a core region of logic circuits; and a peripheral region comprising a first conductor coupled to transmit a first signal between first and second devices that are external to the integrated circuit, wherein the first and second devices are oriented diagonally in a multi-chip module.

In Example 2, the integrated circuit of Example 1 may optionally include, wherein the peripheral region further comprises a time division multiplexer circuit coupled to transmit a second signal to the first device.

In Example 3, the integrated circuit of any one of Examples 1-2 may optionally include, wherein the peripheral region further comprises a time division multiplexer circuit coupled to receive a third signal from the second device.

In Example 4, the integrated circuit of any one of Examples 1-3 may optionally include, wherein the first conductor is coupled to transmit the first signal entirely through the peripheral region without routing the first signal through the core region.

In Example 5, the integrated circuit of any one of Examples 1-4 may optionally include, wherein the peripheral region further comprises: a second conductor coupled to transmit a second signal between the second device and a third device that is external to the integrated circuit.

In Example 6, the integrated circuit of any one of Examples 1-5 may optionally include, wherein the first device is adjacent to a first edge of the integrated circuit, and wherein the second device is adjacent to a second edge of the integrated circuit that is perpendicular to the first edge.

Example 7 is a circuit system comprising: a support device comprising first and second conductors; and first, second, and third integrated circuits that are coupled to the support device, wherein the second integrated circuit comprises a first peripheral region, wherein the first peripheral region comprises a third conductor coupled between the first and the second conductors, wherein the circuit system is configured to transmit a first signal from the first integrated circuit through the first conductor, the third conductor, and the second conductor to the third integrated circuit, and wherein the first and the third integrated circuits are positioned diagonally in the circuit system.

In Example 8, the circuit system of Example 7 may optionally include, wherein the support device comprises a first interconnection bridge that comprises the first conductor and a second interconnection bridge that comprises the second conductor.

In Example 9, the circuit system of any one of Examples 7-8 may optionally include, wherein the second integrated circuit further comprises a core region of logic circuits, and wherein the third conductor is coupled to transmit the first signal entirely through the first peripheral region without routing the first signal through the core region.

In Example 10, the circuit system of any one of Examples 7-9 may optionally include, wherein the first peripheral region of the second integrated circuit further comprises a first time division multiplexer circuit coupled to transmit a second signal through a fourth conductor in the support device to the third integrated circuit.

In Example 11, the circuit system of Example 10 may optionally include, wherein the third integrated circuit comprises a second peripheral region, and wherein the second peripheral region comprises a fifth conductor coupled between the fourth conductor and a sixth conductor in the support device.

In Example 12, the circuit system of Example 11 further comprises: a fourth integrated circuit comprising a second time division multiplexer circuit, wherein the circuit system is configured to transmit the second signal from the first time division multiplexer circuit through the fourth conductor, the fifth conductor, and the sixth conductor to the second time division multiplexer circuit.

In Example 13, the circuit system of any one of Examples 7-12 further comprises: a fourth integrated circuit comprising a second peripheral region, wherein the support device further comprises a fourth conductor coupled between the third and the fourth integrated circuits, wherein the support device further comprises a fifth conductor coupled between the first and the fourth integrated circuits, and wherein the second peripheral region comprises a sixth conductor coupled between the fourth and the fifth conductors.

In Example 14, the circuit system of Example 13 may optionally include, wherein the circuit system is configured to transmit a second signal from the third integrated circuit through the fourth conductor, the fifth conductor, and the sixth conductor to the first integrated circuit.

In Example 15, the circuit system of any one of Examples 7-14 further comprises: a fourth integrated circuit that is vertically stacked on, and coupled to, the first integrated circuit; and a fifth integrated circuit that is vertically stacked on, and coupled to, the third integrated circuit.

Example 16 is a method comprising: transmitting a first signal from a first time division multiplexer circuit in a first integrated circuit through a first conductor in a support device to a second integrated circuit; transmitting the first signal from the first conductor through a second conductor that is routed through a first peripheral region of the second integrated circuit to a third conductor in the support device; and transmitting the first signal from the third conductor to a second time division multiplexer circuit in a third integrated circuit.

In Example 17, the method of Example 16 further comprises: transmitting a second signal from a third time division multiplexer circuit in the second integrated circuit through a fourth conductor in the support device to the first integrated circuit; transmitting the second signal from the fourth conductor through a fifth conductor that is routed through a second peripheral region of the first integrated circuit to a sixth conductor in the support device; and transmitting the second signal from the sixth conductor to a fourth time division multiplexer circuit in a fourth integrated circuit.

In Example 18, the method of any one of Examples 16-17 may optionally include, wherein the second integrated circuit further comprises a core region, and wherein the second conductor is coupled to transmit the first signal entirely through the first peripheral region without routing the first signal through the core region.

In Example 19, the method of any one of Examples 16-18 further comprises: generating the first signal from second signals received from a first core region of the first integrated circuit using the first time division multiplexer circuit; generating third signals from the first signal using the second time division multiplexer circuit; and transmitting the third signals to a second core region of the third integrated circuit.

In Example 20, the method of any one of Examples 16-19 may optionally include, wherein the first, the second, and the third integrated circuits are mounted on the support device, and wherein the first and the third integrated circuits are positioned diagonally in the circuit system.

The foregoing description of the examples has been presented for the purpose of illustration. The foregoing description is not intended to be exhaustive or to be limiting to the examples disclosed herein. In some instances, features of the examples can be employed without a corresponding use of other features as set forth. Many modifications, substitutions, and variations are possible in light of the above teachings.

## Claims

1. A circuit system comprising:
a support device comprising first and second conductors; and
first, second, and third integrated circuits that are coupled to the support device,
wherein the second integrated circuit comprises a first peripheral region, wherein the first peripheral region comprises a third conductor coupled between the first and the second conductors, wherein the circuit system is configured to transmit a first signal from the first integrated circuit through the first conductor, the third conductor, and the second conductor to the third integrated circuit, and wherein the first and the third integrated circuits are positioned diagonally in the circuit system.

2. The circuit system of claim 1, wherein the support device comprises a first interconnection bridge that comprises the first conductor and a second interconnection bridge that comprises the second conductor.

3. The circuit system of any one of claims 1-2, wherein the second integrated circuit further comprises a core region of logic circuits, and wherein the third conductor is coupled to transmit the first signal entirely through the first peripheral region without routing the first signal through the core region.

4. The circuit system of any one of claims 1-3, wherein the first peripheral region of the second integrated circuit further comprises a first time division multiplexer circuit coupled to transmit a second signal through a fourth conductor in the support device to the third integrated circuit.

5. The circuit system of claim 4, wherein the third integrated circuit comprises a second peripheral region, and wherein the second peripheral region comprises a fifth conductor coupled between the fourth conductor and a sixth conductor in the support device.

6. The circuit system of claim 5 further comprising:
a fourth integrated circuit comprising a second time division multiplexer circuit, wherein the circuit system is configured to transmit the second signal from the first time division multiplexer circuit through the fourth conductor, the fifth conductor, and the sixth conductor to the second time division multiplexer circuit.

7. The circuit system of any one of claims 1-6 further comprising: a fourth integrated circuit comprising a second peripheral region, wherein the support device further comprises a fourth conductor coupled between the third and the fourth integrated circuits, wherein the support device further comprises a fifth conductor coupled between the first and the fourth integrated circuits, and wherein the second peripheral region comprises a sixth conductor coupled between the fourth and the fifth conductors.

8. The circuit system of claim 7, wherein the circuit system is configured to transmit a second signal from the third integrated circuit through the fourth conductor, the fifth conductor, and the sixth conductor to the first integrated circuit.

9. The circuit system of any one of claims 1-8 further comprising:
a fourth integrated circuit that is vertically stacked on, and coupled to, the first integrated circuit; and
a fifth integrated circuit that is vertically stacked on, and coupled to, the third integrated circuit.

10. A method comprising:
transmitting a first signal from a first time division multiplexer circuit in a first integrated circuit through a first conductor in a support device to a second integrated circuit;
transmitting the first signal from the first conductor through a second conductor that is routed through a first peripheral region of the second integrated circuit to a third conductor in the support device; and
transmitting the first signal from the third conductor to a second time division multiplexer circuit in a third integrated circuit.

11. The method of claim 10 further comprising:
transmitting a second signal from a third time division multiplexer circuit in the second integrated circuit through a fourth conductor in the support device to the first integrated circuit;
transmitting the second signal from the fourth conductor through a fifth conductor that is routed through a second peripheral region of the first integrated circuit to a sixth conductor in the support device; and
transmitting the second signal from the sixth conductor to a fourth time division multiplexer circuit in a fourth integrated circuit.

12. The method of any one of claims 10-11, wherein the second integrated circuit further comprises a core region, and wherein the second conductor is coupled to transmit the first signal entirely through the first peripheral region without routing the first signal through the core region.

13. The method of any one of claims 10-12 further comprising:
generating the first signal from second signals received from a first core region of the first integrated circuit using the first time division multiplexer circuit;
generating third signals from the first signal using the second time division multiplexer circuit; and
transmitting the third signals to a second core region of the third integrated circuit.

14. The method of any one of claims 10-13, wherein the first, the second, and the third integrated circuits are mounted on the support device.

15. The method of claim 14, wherein the first and the third integrated circuits are positioned diagonally in the circuit system.
